# EUROPEAN PATENT APPLICATION

(11) **EP 4 697 900 A2**
(43) Date of publication of application: **18.02.2026**
(21) Application number: 25223624.5
(22) Date of filing: 16.12.2025
(51) Int. Cl.: H10F 77/20, H10F 71/00, H10F 10/165

(54) **SOLAR CELL SHEET, PREPARATION METHOD THEREFOR AND PHOTOVOLTAIC MODULE**

(30) Priority: 30.05.2025 CN 202510713801
(71) Applicant: HUAI'AN JIETAI NEW ENERGY TECHNOLOGY CO., LTD., Huaian City, Jiangsu 223400 (CN)
(72) Inventor: FAN, Xun, Huaian, 223400 (CN); FU, Shaojian, Huaian, 223400 (CN); ZHANG, Mingming, Huaian, 223400 (CN); CUI, Gege, Huaian, 223400 (CN); ZHANG, Manliang, Huaian, 223400 (CN)
(74) Representative: Metida

(57) **Abstract**

The present invention provides a solar cell sheet and a preparation method therefor and a photovoltaic module, relating to the technical field of photovoltaics. The solar cell sheet comprises a silicon wafer, a doped polysilicon layer, and grid lines, and a thickness of the silicon wafer at a non-grid-line region in an edge portion of the silicon wafer is greater than a thickness of the silicon wafer at a non-grid-line region in a middle portion. In embodiments of the present invention, since the non-grid-line region of the edge portion has a greater thickness relative to the non-grid-line region of the middle portion, structural strength thereof is better than that of the middle portion. This makes the silicon wafer and the solar cell sheet not prone to warping, micro-cracking, or fragmenting, and not prone to being damaged due to impact. In processing of the solar cell sheet, in assembly of a photovoltaic module, and in subsequent use of the photovoltaic module, a silicon wafer having better reliability can enable the solar cell to have a higher product yield, better performance, and a longer service life.

## Description

### TECHNICAL FIELD

The present invention relates to the technical field of photovoltaics, and specifically to a solar cell sheet and a preparation method therefor and a photovoltaic module.

### BACKGROUND ART

A solar cell is influenced by multiple factors during an operation process, wherein stress is a key factor. The generation of stress mainly originates from mismatch of material thermal expansion coefficients in a manufacturing process of the cell sheet, unreasonable structural design of the cell sheet, and temperature change in an actual use environment of the cell sheet. For example, in a preparation process of the solar cell, multiple different materials are usually involved, such as a silicon wafer, a metal electrode, an encapsulation material, etc. These materials have different thermal expansion coefficients, and when experiencing a high-temperature process (such as an annealing process) or temperature change in an outdoor environment, due to different degrees of expansion or contraction of different materials, stress is generated inside the cell. This stress may cause defects such as cracks and delamination of the cell sheet, influencing yield of a product.

At present, in related technologies of a cell sheet preparation process, there exists a process means for etching off a polysilicon layer of a non-grid-line region to improve cell performance. However, during an etching process, the non-grid-line region on an entire silicon wafer is usually corroded by 2-3 µm, and a thickness of an existing solar cell sheet itself is relatively thin, and this process means damages stress of the solar cell sheet to a certain extent, causing a negative influence on long-term stable performance of the cell sheet and the module. For example, the cell sheet may generate warpage, micro-cracks, or even fragmentation during a high-temperature process (for example, film deposition, sintering); and the cell sheet is also more likely to crack or break when suffering impact.

### SUMMARY

The objectives of the present invention include providing a solar cell sheet and a preparation method therefor and a photovoltaic module, which can optimize stress of the silicon wafer and improve reliability of the solar cell sheet.

The embodiments of the present invention can be implemented as follows.

In a first aspect, the present invention provides a solar cell sheet, and the solar cell sheet is a tunnel oxide passivated contact cell or a back contact cell. The solar cell sheet comprises a silicon wafer, a doped polysilicon layer, and grid lines, wherein at least one surface of the silicon wafer has a grid-line region and a non-grid-line region, the doped polysilicon layer covers the grid-line region, and the grid lines are connected to the doped polysilicon layer.

The silicon wafer has a middle portion and an edge portion, wherein the edge portion forms an edge of the silicon wafer and surrounds the middle portion, a dimension of the edge portion in a width direction of the edge portion is 1% to 30% of a dimension of the silicon wafer in the same direction. The width direction of the edge portion is parallel to the silicon wafer and perpendicular to the edge of the silicon wafer. A thickness of the silicon wafer at the non-grid-line region in the edge portion is greater than a thickness of the silicon wafer at the non-grid-line region in the middle portion.

In an optional embodiment, the dimension of the edge portion in the width direction of the edge portion is 1 mm to 70 mm.

In an optional embodiment, the non-grid-line region of the silicon wafer forms a groove, and a depth of the groove in the edge portion is less than a depth of the groove in the middle portion.

In an optional embodiment, the depth of the groove in the edge portion is 0.1 µm to 3 µm, and the depth of the groove in the middle portion is 1 µm to 5 µm.

In an optional embodiment, the groove is formed on a back surface of the silicon wafer.

In a second aspect, the present invention provides a preparation method for the solar cell sheet as described in any of the preceding embodiments, including:
obtaining the silicon wafer;
depositing the doped polysilicon layer on the silicon wafer;
etching to remove the doped polysilicon layer and a portion of the silicon wafer in the non-grid-line region, wherein an etching depth of the silicon wafer in the middle portion is greater than an etching depth of the silicon wafer in the edge portion; and
forming grid lines connected to the doped polysilicon layer.

In an optional embodiment, the step of etching to remove the doped polysilicon layer and a portion of the silicon wafer in the non-grid-line region comprises:
irradiating the doped polysilicon layer in the non-grid-line region with a laser; and
removing the doped polysilicon layer and the portion of the silicon wafer in the non-grid-line region by a wet etching process.

In an optional embodiment, in the step of irradiating the doped polysilicon layer in the non-grid-line region with a laser, a unit area laser energy of the non-grid-line region in the middle portion is greater than a unit area laser energy of the non-grid-line region in the edge portion.

In an optional embodiment, the unit area laser energy of the non-grid-line region in the middle portion is 210 mJ/cm² to 380 mJ/cm²; and the unit area laser energy of the non-grid-line region in the edge portion is 180 mJ/cm² to 350 mJ/cm².

In an optional embodiment, in the step of irradiating the doped polysilicon layer in the non-grid-line region with a laser, an irradiation duration of the non-grid-line region in the middle portion is greater than an irradiation duration of the non-grid-line region in the edge portion, and/or an irradiation power of the non-grid-line region in the middle portion is greater than an irradiation power of the non-grid-line region in the edge portion.

In an optional embodiment, the step of removing the doped polysilicon layer and the portion of the silicon wafer in the non-grid-line region by a wet etching process comprises:
etching the non-grid-line region in the middle portion using a first etching solution, and etching the non-grid-line region in the edge portion using a second etching solution, wherein
a corrosiveness of the first etching solution is stronger than a corrosiveness of the second etching solution, and/or a concentration of the first etching solution is greater than a concentration of the second etching solution.

In an optional embodiment, in the step of removing the doped polysilicon layer and the portion of the silicon wafer in the non-grid-line region by a wet etching process, an etching duration of the middle portion is greater than an etching duration of the edge portion, and/or an etching temperature of the middle portion is higher than an etching temperature of the edge portion.

In an optional embodiment, the laser is a green laser.

In an optional embodiment, the etching solution used in the wet etching process comprises at least one of sodium hydroxide and potassium hydroxide.

In a third aspect, the present invention provides a photovoltaic module, comprising the solar cell sheet of any one of the foregoing embodiments, or comprising the solar cell sheet prepared by the preparation method for the solar cell sheet of any one of the foregoing embodiments.

Beneficial effects of the solar cell sheet, the preparation method therefor, and the photovoltaic module provided by embodiments of the present invention comprise the following.

The solar cell sheet provided by embodiments of the present invention is a tunnel oxide passivated contact cell or a back contact cell, which comprises a silicon wafer, a doped polysilicon layer, and grid lines. At least one surface of the silicon wafer has a grid-line region and a non-grid-line region, the doped polysilicon layer covers the grid-line region, and the grid lines are connected to the doped polysilicon layer. The silicon wafer has a middle portion and an edge portion, the edge portion forms an edge of the silicon wafer and surrounds the middle portion, and a thickness of the silicon wafer at the non-grid-line region of the edge portion is greater than a thickness of the silicon wafer at the non-grid-line region of the middle portion. In embodiments of the present invention, since the non-grid-line region of the edge portion has a greater thickness relative to the non-grid-line region of the middle portion, structural strength thereof is better than that of the middle portion. Since the edge portion is exactly a position prone to warping and micro-cracking and also a position prone to being bumped, strengthening the edge portion of the silicon wafer in embodiments of the present invention can improve reliability of the entire silicon wafer and even the entire solar cell sheet. This makes the silicon wafer and the solar cell sheet not prone to warping, micro-cracking, or fragmenting, and not prone to being damaged due to collision. In processing of the solar cell sheet, in assembly of a photovoltaic module, and in subsequent use of the photovoltaic module, a silicon wafer having better reliability can enable the solar cell sheet to have a higher product yield, better performance, and a longer service life.

The preparation method for solar cell sheet provided by embodiments of the present invention can be used for preparing the above solar cell sheet, and the photovoltaic module provided by embodiments of the present invention comprises the above solar cell sheet or the solar cell sheet prepared by the above preparation method. Therefore, the photovoltaic module also has characteristics of high product yield, good reliability, and long service life.

### BRIEF DESCRIPTION OF DRAWINGS

In order to more clearly illustrate the technical solutions of the embodiments of the present invention, the following will briefly introduce the drawings used in the embodiments. It should be understood that the following drawings only show some embodiments of the present invention, and therefore it should not be regarded as a limitation on the scope. Those ordinary skilled in the art can also obtain other related drawings based on these drawings without inventive effort.
FIG. 1 is a schematic diagram of a back surface of a solar cell sheet in one embodiment of the present invention;
FIG. 2 is a partial sectional view of a solar cell sheet (TOPCon cell) in one embodiment of the present invention;
FIG. 3 is a schematic diagram of a silicon wafer in one embodiment of the present invention;
FIG. 4 is a partial sectional view of a solar cell sheet (BC cell) in another embodiment of the present invention;
FIG. 5 is a flowchart of a preparation method for the solar cell sheet in one embodiment of the present invention;
FIG. 6 is a schematic view after preparation of a doped polysilicon layer in one embodiment of the present invention;
FIG. 7 is a schematic view after preparation of a p-type doped polysilicon layer in one embodiment of the present invention;
FIG. 8 is a schematic view after preparation of a n-type doped polysilicon layer in one embodiment of the present invention;
FIG. 9 is a flowchart of etching to remove a doped polysilicon layer in a non-grid-line region and a portion of the silicon wafer in one embodiment of the present invention;
FIG. 10 is a schematic view after etching to remove the doped polysilicon layer in the non-grid-line region in one embodiment of the present invention; and
FIG. 11 is a schematic view after etching to remove the doped polysilicon layer in the non-grid-line region in another embodiment of the present invention.

Reference numerals: 010 - solar cell sheet; 100 - silicon wafer; 101 - middle portion; 102 - edge portion; 110 - grid-line region; 120 - non-grid-line region; 200 - grid line; 201 - first grid line; 202 - second grid line; 300 - p-type doped polysilicon layer; 310 - first dielectric layer; 400 - n-type doped polysilicon layer; 410 - second dielectric layer; 500 - tunneling oxide layer; 610 - first passivation layer; 620 - second passivation layer.

### DETAILED DESCRIPTION OF EMBODIMENTS

In order to make the objective, technical solutions, and advantages of the embodiments of the present invention clearer, the following description will provide a clear and comprehensive explanation of the technical solutions in the embodiments of the present invention with reference to the drawings of the present invention. Clearly, the described embodiments are part of the embodiments of the present invention and not the entire embodiments. The components of embodiments of the present invention which are generally described and illustrated in the drawings herein can be arranged and designed in a variety of different configurations.

Accordingly, the following detailed description of the embodiments of the present invention provided in the drawings is not intended to limit the scope of the present invention for which protection is claimed, but merely represents selected embodiments of the present invention. Based on the embodiments in the present invention, all other embodiments obtained by those of ordinary skill in the art without making inventive efforts are within the scope of protection of the present invention.

It should be noted that similar numerals and letters denote similar terms in the following drawings so that once an item is defined in one drawing, it does not need to be further defined or discussed in subsequent drawings.

In the description of the present invention, it should be noted that the orientation or position relationships indicated by the terms "up", "down", "inside", "outside", etc. are the orientation or position relationships shown based on the drawings or the orientation or position relationships customarily placed in the use of the product of the present invention. It is only for the convenience of describing the present invention and simplifying its description, and does not indicate or imply that the device or element referred to must be in a specific orientation or be constructed and operated in a specific orientation, and thus should not be construed as limiting the present invention.

In addition, the terms such as "first", "second", are only used to distinguish the descriptive and are not to be construed as indicating or implying relative importance.

It should be noted that the features in the embodiments of the present invention may be combined with each other without conflict.

A polysilicon layer on a back surface of a solar cell has a parasitic absorption phenomenon, influencing photoelectric conversion efficiency of solar cell sheet 010. Parasitic absorption refers to a phenomenon in which photons are absorbed by a non-active layer or a non-ideal position instead of being absorbed by an active layer (such as a perovskite layer, a monocrystalline or polysilicon layer) designed to generate electric energy. Polysilicon is composed of many small silicon crystals, and grain boundaries and defects are numerous, and these regions may generate additional absorption for specific wavelengths of light. In addition, impurities and structural defects in polysilicon can cause scattering and absorption of photon energy. This unnecessary absorption causes loss of photogenerated carriers, thereby reducing overall conversion efficiency of the solar cell. In related technologies, to improve a parasitic absorption problem of a back surface of the solar cell sheet, a doped polysilicon layer of a non-grid-line region on the back surface of the solar cell sheet is removed. For example, by performing laser irradiation on all non-grid-line regions of the back surface of the solar cell sheet, for acting on the doped polysilicon layer of the non-grid-line region and a phosphosilicate glass (PSG) film on a surface thereof, the PSG film is removed under action of the laser or generates delamination with the doped polysilicon layer (that is, laser opening), and subsequently an etching process is used to completely remove the doped polysilicon layer of the non-grid-line region, and only the doped polysilicon layer of the grid-line region is retained. Although a back-surface etching process in related technologies can improve a parasitic absorption problem of the back polysilicon layer, since an etching depth cannot be precisely controlled in the etching process, to ensure that the polysilicon layer of the non-grid-line region on the back surface is completely removed, the silicon wafer below the polysilicon layer is etched to a certain extent. Usually, the non-grid-line region on the back surface of the silicon wafer is uniformly etched by 2-3 µm. However, an overall thickness of the solar cell sheet itself is relatively thin (usually below 150 µm), and this etching process makes reliability of the silicon wafer relatively poor, especially reliability of an edge portion of the silicon wafer is relatively poor. Due to a high-temperature process in subsequent procedures (for example, film deposition, sintering), the solar cell sheet easily generates warpage, and risks of micro-cracks and fragmentation also increase. Furthermore, the silicon wafer / solar cell sheet easily generates edge damage or even fragmentation due to impact during manufacturing and assembling. Therefore, a preparation method for the solar cell sheet in related technologies generates a relatively large negative influence on structural strength of the silicon wafer / solar cell sheet, causing negative influences such as reduced product yield, deteriorated product reliability, and shortened service life.

To improve at least one deficiency in the related technologies above, embodiments of the present invention provide a solar cell sheet and a preparation method therefor, by making a thickness of a non-grid-line region of an edge portion of the silicon wafer greater than a thickness of a non-grid-line region of a middle portion of the silicon wafer, thereby improving strength of the edge portion of the silicon wafer relative to the middle portion of the silicon wafer, reducing warpage by optimizing stress distribution of the silicon wafer, reducing risks of micro-cracks and fragmentation, and simultaneously reducing risks of damage caused by edge impact. Thus, product yield, reliability, and service life of the solar cell sheet are improved.

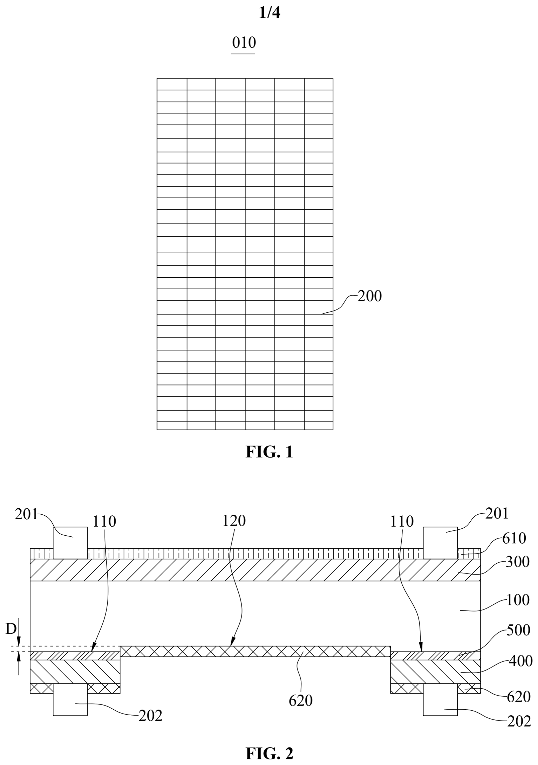

FIG. 1 is a schematic diagram of a back surface of a solar cell sheet 010 in one embodiment of the present invention. As shown in FIG. 1, the back surface of solar cell sheet 010 provided by the embodiment of the present invention has several grid lines 200, and these grid lines 200 are made of metal materials and act as metal electrodes to collect current, and photogenerated current generated by solar cell sheet 010 can be transmitted to external energy storage equipment or a power grid through grid lines 200. A type of the solar cell sheet 010 provided by the embodiment of the present invention can be a tunnel oxide passivated contact (TOPCon) cell or a back contact (BC) cell, and can also be other solar cell sheets requiring removal of a doped polysilicon layer of a back-surface non-grid-line region 120 (also referred to as non-metallization region).

FIG. 2 is a partial sectional view of a solar cell sheet 010 (TOPCon cell) in one embodiment of the present invention. As shown in FIG. 2, the solar cell sheet 010 shown in FIG. 2 is a tunnel oxide passivated contact cell, that is, a TOPCon cell, comprising a silicon wafer 100 and a doped polysilicon layer and grid lines 200 provided on the silicon wafer 100. The silicon wafer 100 has a front surface and a back surface opposite to each other in a thickness direction of the silicon wafer 100, the front surface corresponds to a light-receiving surface of solar cell sheet 010, and the back surface corresponds to a shaded surface of solar cell sheet 010. In FIG. 2, an upper surface of the silicon wafer 100 is the front surface, and a lower surface of the silicon wafer 100 is the back surface.

In the embodiment, the doped polysilicon layer comprises a p-type doped polysilicon layer 300 and an n-type doped polysilicon layer 400. In addition, solar cell sheet 010 further comprises a tunneling oxide layer 500, a first passivation layer 610, and a second passivation layer 620. In the embodiment, the p-type doped polysilicon layer 300 is provided on a light-receiving side of the silicon wafer 100, and the first passivation layer 610 is provided on a side of the p-type doped polysilicon layer 300 away from the silicon wafer 100. The back surface of the silicon wafer 100 has a grid-line region 110 and a non-grid-line region 120, the tunneling oxide layer 500 and the n-type doped polysilicon layer 400 are arranged in a laminated manner on the grid-line region 110 of the back surface, and the second passivation layer 620 is provided on the non-grid-line region 120 and on a side of the n-type doped polysilicon layer 400 away from the silicon wafer 100. It should be understood that the grid-line region 110 on the back surface of the silicon wafer 100 in the embodiment of the present invention is a region covered by the n-type doped polysilicon layer 400, and the non-grid-line region 120 is a region on the back surface of the silicon wafer 100 not covered by the n-type doped polysilicon layer 400. The grid lines 200 comprise a first grid line 201 and a second grid line 202, wherein the first grid line 201 is connected to the p-type doped polysilicon layer 300, and the second grid line 202 is connected to the n-type doped polysilicon layer 400.

In the embodiment, the silicon wafer 100 is n-type doped, and specifically can be n-type monocrystalline silicon. Materials of the first passivation layer 610 and the second passivation layer 620 are selected from at least one of aluminum oxide, silicon oxide, silicon nitride, and silicon oxynitride. The first passivation layer 610 and the second passivation layer 620 can cover the front surface and the back surface of solar cell sheet 010, can effectively reduce surface state density and reduce carrier recombination on the surface, thereby improving open-circuit voltage (Voc) and conversion efficiency of the cell. The first passivation layer 610 (such as adopting SiNₓ) can also have an anti-reflection function, can reduce reflection loss of incident light, and increase light absorption, thereby improving short-circuit current (Isc). The second passivation layer 620, together with the tunneling oxide layer 500 and the n-type doped polysilicon layer 400, forms a passivated contact structure, and can optimize transmission and collection efficiency of carriers. In addition, the first passivation layer 610 and the second passivation layer 620 can protect the silicon wafer 100 and the doped polysilicon layer from influence of an external environment (such as moisture and contaminants), and improve long-term stability of solar cell sheet 010.

The tunneling oxide layer 500 can effectively reduce a recombination rate on a back surface and improve open-circuit voltage (Voc) of the cell, and the tunneling oxide layer 500, as an interface layer between the silicon wafer 100 and the n-type doped polysilicon layer 400, can optimize interface characteristics, reduce interface defects, and improve transmission efficiency of carriers. A material of the tunneling oxide layer 500 can be selected as SiO₂, and the tunneling oxide layer 500 allows electrons to pass through by a quantum tunneling effect and blocks holes, thereby realizing selective transmission of carriers. The tunneling oxide layer 500 usually has a relatively small thickness, for example, a thickness of 1nm to 2nm.

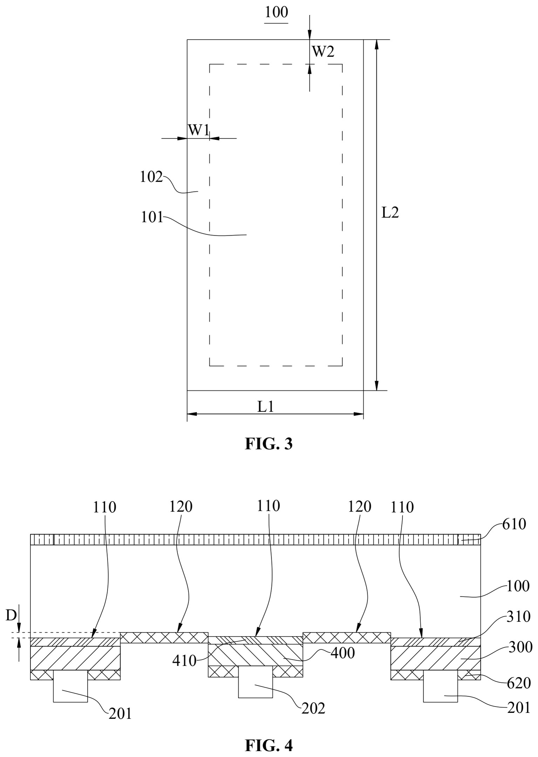

FIG. 3 is a schematic diagram of a silicon wafer 100 in one embodiment of the present invention. In combination with FIG. 2 and FIG. 3, in the embodiment of the present invention, the silicon wafer 100 has a middle portion 101 and an edge portion 102, the edge portion 102 forms an edge of the silicon wafer 100 and surrounds the middle portion 101, and a thickness of the silicon wafer 100 at the non-grid-line region 120 of the edge portion 102 is greater than a thickness of the silicon wafer 100 at the non-grid-line region 120 of the middle portion 101. It can be understood that an area occupied by the non-grid-line region 120 is usually greater than an area occupied by the grid-line region 110, and a thickness of the silicon wafer 100 at the non-grid-line region 120 has a significant influence on structural strength of the silicon wafer 100. Usually, the edge portion 102 of the silicon wafer 100 is prone to warping relative to the middle portion 101 and more prone to impact, and therefore the edge portion 102 is a weak position of the silicon wafer 100 and prone to warping and micro-cracks. In the embodiment of the present invention, since the thickness of the silicon wafer 100 at the non-grid-line region 120 of the edge portion 102 is greater than the thickness of the silicon wafer 100 at the non-grid-line region 120 of the middle portion 101, the edge portion 102 of the silicon wafer 100 has higher structural strength than the middle portion 101 of the silicon wafer 100, and this form of the silicon wafer 100 is not prone to warping and can also reduce a risk of fragmenting of the silicon wafer 100 caused by impact. Since solar cell sheet 010 is not prone to warping and has relatively good strength, solar cell sheet 010 can facilitate subsequent processing and assembly and is not prone to damage, which is beneficial to improving product yield. After being assembled into a photovoltaic module and put into use, since solar cell sheet 010 has relatively good reliability, service life will also be improved.

As shown in FIG. 3, a portion enclosed by dotted lines is the middle portion 101 of the silicon wafer 100, and a portion between the dotted lines and an edge of the silicon wafer 100 is the edge portion 102 of the silicon wafer 100. Optionally, the middle portion 101 of the silicon wafer 100 and the silicon wafer 100 are rectangular. Optionally, the middle portion 101 of the silicon wafer 100 and the silicon wafer 100 have similar shapes (that is, have the same length-to-width ratio). In other optional embodiments, the middle portion 101 of the silicon wafer 100 can also be selected as other shapes as required, for example, circular, oval, triangular, trapezoidal, or other irregular shapes, as long as an edge of the middle portion 101 of the silicon wafer 100 has a spacing from an edge of the silicon wafer 100.

Optionally, a size of the edge portion 102 in a width direction of the edge portion 102 (W1 and W2 shown in the figure) is 1% to 30% of a size of the silicon wafer 100 in a same direction, for example, any percentage value of 1%, 2%, 5%, 10%, 15%, 20%, 25%, or 30% of a size of the silicon wafer 100 in the same direction, or a value between any two of these percentage values. The width direction of the edge portion 102 is parallel to the silicon wafer 100 and perpendicular to an edge of the silicon wafer 100. In the embodiment, since the edge portion 102 surrounds the middle portion 101, the width direction of the edge portion 102 exists in different directions. As shown in FIG. 3, for edge portions 102 on left and right sides, their width direction is a left-right direction and is parallel to a width direction of the silicon wafer 100, and a width of the edge portion 102 (shown as W1 in FIG. 3) accounts for 1% to 30% of a width of the silicon wafer 100 (shown as L1 in FIG. 3). For edge portions 102 on upper and lower sides, their width direction is an up-down direction and is parallel to a length direction of the silicon wafer 100, and a width of the edge portion 102 (shown as W2 in FIG. 3) accounts for 1% to 30% of a length of the silicon wafer 100 (shown as L2 in FIG. 3).

Optionally, a size of the edge portion 102 in the width direction thereof is 1mm to 70mm, for example, a width of the edge portion 102 is any one of point values or a value between any two of point values among 1mm, 2mm, 5mm, 10mm, 15mm, 20mm, 30mm, 40mm, 50mm, 60mm, and 70mm.

In the embodiment, the non-grid-line region 120 on the back surface of the silicon wafer 100 forms a groove, which is formed by excessive etching during a wet etching process for removing a doped polysilicon layer (specifically the n-type doped polysilicon layer 400 in the present embodiment) on the back surface, in order to ensure complete removal of the doped polysilicon layer. In other optional embodiments, the silicon wafer 100 at part of the non-grid-line region 120 can also be not etched and no groove is formed. For example, the non-grid-line region 120 in the edge portion 102 of the silicon wafer 100 can be not etched (that is, just etched to a surface of the silicon wafer 100). It can be understood that when the silicon wafer 100 is not etched, its thickness can be uniform, and by adjusting a depth of the silicon wafer 100 etched in the non-grid-line region 120, that is, adjusting a groove depth (shown as D in FIG. 2), a thickness of the silicon wafer 100 at the non-grid-line region 120 can be adjusted.

In the embodiment of the present invention, a groove depth of the edge portion 102 is less than a groove depth of the middle portion 101, therefore a thickness of the silicon wafer 100 at the non-grid-line region 120 of the edge portion 102 is greater than a thickness of the silicon wafer 100 at the non-grid-line region 120 of the middle portion 101. Optionally, a groove depth of the edge portion 102 is 0.1µm to 3µm, for example, any one of point values or a value between any two of point values among 0.1µm, 0.2µm, 0.5µm, 1µm, 1.5µm, 2µm, 2.5µm, and 3µm; and a groove depth of the middle portion 101 is 1µm to 5µm, for example, any one of point values or a value between any two of point values among 1µm, 1.5µm, 2µm, 2.5µm, 3µm, 3.5µm, 4µm, 4.5µm, and 5µm. It can be understood that when the groove depth is designed to be excessively deep, a problem that the strength of the silicon wafer 100 decreases is easily caused, and when the groove depth is designed to be excessively shallow, a problem that the doped polysilicon layer is not completely removed is easily caused. In optional other embodiments, the depth of the groove can further be selected outside the above range according to actual product requirements, for example, when a thicker silicon wafer 100 is used, considering increasing the depth of the groove.

The above embodiment of FIG. 2 is introduced by taking a TOPCon cell as an example. The solar cell sheet 010 provided by embodiments of the present invention can further be a back contact cell (that is, a BC cell). FIG. 4 is a partial sectional view of a solar cell sheet 010 (that is, the BC cell) in another embodiment of the present invention. As shown in FIG. 4, the solar cell sheet 010 includes a solar cell including the silicon wafer 100, the doped polysilicon layer arranged on the silicon wafer 100, and the grid lines 200. In FIG. 4, a front surface of the silicon wafer 100 faces upward, corresponding to a light-receiving side of the solar cell sheet 010, and a back surface of the silicon wafer 100 faces downward, corresponding to a shaded side of the solar cell sheet 010. The doped polysilicon layer includes the p-type doped polysilicon layer 300 and the n-type doped polysilicon layer 400. The solar cell sheet 010 further includes the first dielectric layer 310, the second dielectric layer 410, the first passivation layer 610, and the second passivation layer 620. The first passivation layer 610 is arranged on the front surface of the silicon wafer 100. The first dielectric layer 310 and the p-type doped polysilicon layer 300 are sequentially arranged in a laminated manner on a part of the grid-line region 110 on the back surface of the silicon wafer 100, and the second dielectric layer 410 and the n-type doped polysilicon layer 400 are sequentially arranged in a laminated manner on another part of the grid-line region 110 on the back surface of the silicon wafer 100. The second passivation layer 620 is arranged on a side of the p-type doped polysilicon layer 300 away from the silicon wafer 100, a side of the n-type doped polysilicon layer 400 away from the silicon wafer 100, and the non-grid-line region 120 on the back surface of the silicon wafer 100.

In the embodiment shown in FIG. 4, the grid line 200 specifically includes first grid lines 201 and second grid lines 202, wherein the first grid lines 201 are connected to the p-type doped polysilicon layer 300, and the second grid lines 202 are connected to the n-type doped polysilicon layer 400. In the embodiment, a feature of the back contact cell is that the grid line 200 is not provided on the light-receiving side, and the grid lines 200 (including the first grid lines 201 and the second grid lines 202) are all arranged on the back surface of the cell, which means that the light-receiving side of the cell has no grid line 200 shielding sunlight, so that the entire area of the light-receiving side of the solar cell sheet 010 can receive sunlight, which makes it have high photoelectric conversion efficiency and increases photogenerated current. In addition, because the grid lines 200 are all located on the shaded side, a front surface of the cell can be made more concise and flatter, with high aesthetic degree, which is suitable for application scenarios with high aesthetic requirements, such as building-integrated photovoltaic (BIPV) systems. In the embodiment shown in FIG. 4, the non-grid-line region 120 on the back surface of the silicon wafer 100 also forms the groove, and the depth of the groove is shown as D in FIG. 4.

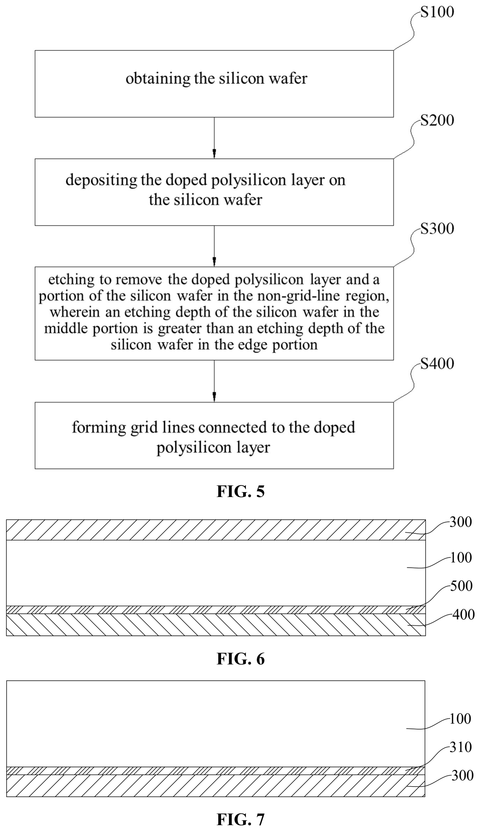

FIG. 5 is a flowchart of a preparation method for the solar cell sheet 010 in one embodiment of the present invention. As shown in FIG. 5, the preparation method for the solar cell sheet 010 provided by embodiments of the present invention can be used for preparing the solar cell sheet 010 provided by the above embodiments of the present invention. The preparation method for the solar cell sheet 010 includes the following steps.

Step S100: obtaining the silicon wafer 100.

In the embodiment of the present invention, the obtained silicon wafer 100 is an n-type doped monocrystalline silicon. Taking the TOPCon cell shown in FIG. 2 as an example, optionally, the front surface of the silicon wafer 100 can be textured to form a textured surface, thereby reducing light-reflection loss, improving light-absorption efficiency, reducing surface recombination, and improving cell performance. Optionally, a base solution (for example, a sodium hydroxide solution) can be adopted to etch the surface of the silicon wafer 100 to form the textured surface.

Step S200: depositing the doped polysilicon layer on the silicon wafer 100.

Taking the TOPCon cell shown in FIG. 2 as an example, it is necessary that a p-type doped polysilicon layer 300 is deposited on the front surface of the silicon wafer 100, an n-type doped polysilicon layer 400 is deposited on the front surface of the silicon wafer 100, and before depositing the n-type doped polysilicon layer 400, a tunneling oxide layer 500 is fabricated on the back surface of the silicon wafer 100. Optionally, the doped polysilicon layer can be fabricated by adopting a chemical vapor deposition (CVD) process, and the tunneling oxide layer 500 can be fabricated by adopting a thermal oxidation process or a chemical vapor deposition process. For example, the silicon wafer 100 is first placed in chemical vapor deposition equipment, and a silicon source (for example, high-purity SiH₄) is introduced to grow an intrinsic polysilicon layer on the front surface of the silicon wafer 100. Subsequently, the above structure is placed in a boron-diffusion furnace tube, and BCl₃ is introduced to perform boron diffusion, thereby converting the intrinsic polysilicon layer into the p-type doped polysilicon layer 300. The previously fabricated structure is placed in CVD equipment. High-purity oxygen is introduced to grow the tunneling oxide layer 500 on the back surface of the silicon wafer 100. Subsequently, a silicon source (for example, high-purity SiH₄) is introduced to grow an intrinsic polysilicon layer on the surface of the tunneling oxide layer 500. The above structure is then placed in a phosphorus-diffusion furnace tube, and POCl₃ is introduced to perform phosphorus diffusion so that the intrinsic polysilicon layer is converted into the n-type doped polysilicon layer 400. It is understood that the process gases used in the above doping processes can be selected based on the desired n-type doping element and p-type doping element, and are not limited to BCl₃ and POCl₃. When the doped polysilicon layers are fabricated, the structure shown in FIG. 6 is obtained.

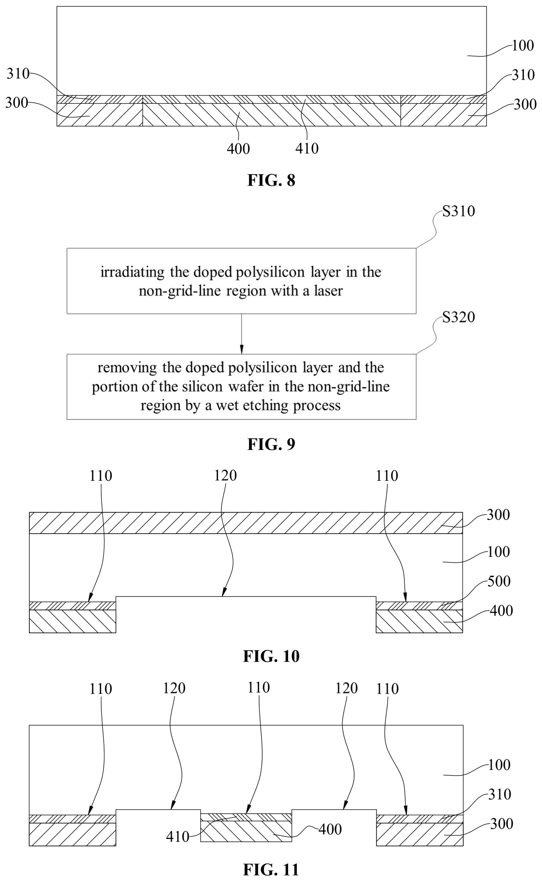

Taking the BC cell shown in FIG. 4 as an example, a first dielectric layer 310 and a p-type doped polysilicon layer 300 can be first deposited sequentially on the back surface of the silicon wafer 100. A chemical vapor deposition process can be specifically adopted to implement the fabrication. Specifically, the silicon wafer 100 can be first placed in chemical vapor deposition equipment, and high-purity oxygen is introduced to grow the first dielectric layer 310 on the back surface of the silicon wafer 100. Subsequently, a silicon source (for example, high-purity SiH₄) is introduced to grow an intrinsic polysilicon layer on the first dielectric layer 310. The above structure is then placed in a boron-diffusion furnace tube, and BCl₃ is introduced to perform boron diffusion so that the intrinsic polysilicon layer is converted into the p-type doped polysilicon layer 300, thereby obtaining the structure shown in FIG. 7. Subsequently, a laser can be adopted to remove part of the first dielectric layer 310 and part of the p-type doped polysilicon layer 300 to expose a portion of the back surface of the silicon wafer 100. Then, a second dielectric layer 410 and an n-type doped polysilicon layer 400 are grown sequentially on the exposed surface of the silicon wafer 100. Specifically, the steps of growing the second dielectric layer 410 and the n-type doped polysilicon layer 400 include: placing the previously fabricated structure in vapor deposition equipment, introducing high-purity oxygen to grow the second dielectric layer 410 on the exposed back surface of the silicon wafer 100, then introducing a silicon source (for example, high-purity SiH₄) to grow an intrinsic polysilicon layer on the second dielectric layer 410, and placing the above structure in a phosphorus-diffusion furnace tube, and introducing POCl₃ to perform phosphorus diffusion so that the intrinsic polysilicon layer is converted into the n-type doped polysilicon layer 400, thereby obtaining the structure shown in FIG. 8. It is understood that the process gases used in the above doping processes can be selected based on the desired n-type doping element and p-type doping element, and are not limited to POCl₃ and BCl₃.

Step S300: etching to remove the doped polysilicon layer and a portion of the silicon wafer 100 in the non-grid-line region 120, wherein an etching depth of the silicon wafer 100 in the middle portion 101 is greater than an etching depth of the silicon wafer 100 in the edge portion 102.

FIG. 9 is a flowchart of etching to remove a doped polysilicon layer in a non-grid-line region 120 and a portion of the silicon wafer 100 in one embodiment of the present invention. As shown in FIG. 9, in the embodiment of the present invention, Step S300 specifically includes step S310 and step S320.

S310: irradiating the doped polysilicon layer in the non-grid-line region 120 with a laser.

It is understood that, during preparation process of the doped polysilicon layer (including the p-type doped polysilicon layer 300 and the n-type doped polysilicon layer 400), a phosphosilicate glass (PSG) film forms on a surface of the n-type doped polysilicon layer 400 and a boron silicate glass (BSG) film forms on a surface of the p-type doped polysilicon layer 300. Laser irradiation is performed on all non-grid-line regions 120 at a back surface of the solar cell sheet 010, and the doped polysilicon layer acting in the non-grid-line regions 120 together with the PSG film (and/or the BSG film) on its surface is subjected to the laser irradiation. The PSG film melts or vaporizes or peels from the doped polysilicon layer under laser irradiation, thereby achieving laser opening. Laser opening facilitates complete removal of the doped polysilicon layer in the non-grid-line regions 120 by using a subsequent wet etching process and retention of only the doped polysilicon layer in the grid-line regions 110.

To achieve a final etching depth of the silicon wafer 100 in the middle portion 101 greater than an etching depth of the silicon wafer 100 in the edge portion 102, non-uniform laser irradiation can be used in step S310. For example, in the step of irradiating the doped polysilicon layer in the non-grid-line region 120 with a laser, a unit area laser energy of the non-grid-line region 120 in the middle portion 101 is greater than a unit area laser energy of the non-grid-line region 120 in the edge portion 102. Through the above non-uniform laser irradiation, the doped polysilicon layer and the PSG film (and/or the BSG film) in the non-grid-line region 120 of the middle portion 101 are affected more strongly by the laser, can generate more heat, and undergo melting or vaporization to a greater extent. Thus, during the subsequent etching process, the doped polysilicon layer in the middle portion 101 is more easily corroded relative to the doped polysilicon layer in the edge portion 102.

Optionally, the unit area laser energy at the non-grid-line region 120 of the middle portion 101 is 210 mJ/cm²-380 mJ/cm², for example, any point value of 210 mJ/cm², 230 mJ/cm², 250 mJ/cm², 270 mJ/cm², 290 mJ/cm², 310 mJ/cm², 330 mJ/cm², 350 mJ/cm², 370 mJ/cm² or 380 mJ/cm², or any value between any two of these point values. The unit area laser energy at the non-grid-line region 120 of the edge portion 102 is 180 mJ/cm²-350 mJ/cm², for example, any point value of 180 mJ/cm², 200 mJ/cm², 220 mJ/cm², 240 mJ/cm², 260 mJ/cm², 280 mJ/cm², 300 mJ/cm², 320 mJ/cm², 340 mJ/cm² or 350 mJ/cm², or any value between any two of these point values.

It is understood that a difference in the unit area laser energy received by the middle portion 101 and the edge portion 102 can be achieved by applying lasers of the same power for different irradiation durations, or applying lasers of different power for the same irradiation duration, or applying lasers different in both power and irradiation duration to the middle portion 101 and the edge portion 102. Therefore, in the optional embodiment of the present invention, an irradiation duration of the non-grid-line region 120 in the middle portion 101 is greater than an irradiation duration of the non-grid-line region 120 in the edge portion 102, and/or an irradiation power of the non-grid-line region 120 in the middle portion 101 is greater than an irradiation power of the non-grid-line region 120 in the edge portion 102.

It is understood that a scanning speed, frequency, power, and spot size of the laser can directly influence the laser energy applied. In an optional embodiment, an initial frequency of the laser can be 600 K and a scanning speed can be 45-60 m/s. Optionally, a laser used in step S310 can be green laser. Optionally, by improving a control algorithm and hardware performance of a scanning galvanometer, the scanning galvanometer can dynamically adjust a scanning speed and scanning angle of the laser beam according to a preset energy distribution mode during scanning. For example, the scanning speed is increased appropriately when scanning the edge portion 102 to reduce a laser acting duration on the edge portion 102 and reduce the laser energy applied to the edge portion 102, and the scanning speed is reduced when scanning the middle portion 101 to accumulate more energy in the middle portion 101.

Step S320: removing the doped polysilicon layer and the portion of the silicon wafer 100 in the non-grid-line region 120 by a wet etching process.

It is understood that the non-grid-line region 120 irradiated by the laser can be etched away, and the non-grid-line region 120 not irradiated by the laser is not etched. To ensure complete removal of the doped polysilicon layer in the non-grid-line region 120 and exposure of the silicon wafer 100, the back surface of the silicon wafer 100 (particularly in the non-grid-line region 120 of the middle portion 101) is also corroded to some extent, thereby forming a groove. If the non-uniform laser irradiation has been performed on the middle portion 101 and the edge portion 102 in step S310, for example, a unit area laser energy of the non-grid-line region 120 in the middle portion 101 is greater than a unit area laser energy of the non-grid-line region 120 in the edge portion 102, then when using the same technical parameters of the wet etching process on the middle portion 101 and the edge portion 102, the non-grid-line region 120 of the middle portion 101 of the silicon wafer 100 produces a deeper groove, resulting in a thickness of the silicon wafer 100 at the non-grid-line region 120 of the middle portion 101 smaller than a thickness of the silicon wafer 100 at the non-grid-line region 120 of the edge portion 102.

In other embodiments, non-uniform etching can be achieved by applying different wet etching processes to the middle portion 101 and the edge portion 102. For example, a first etching solution is used to etch the non-grid-line region 120 of the middle portion 101 and a second etching solution is used to etch the non-grid-line region 120 of the edge portion 102. A corrosiveness of the first etching solution is stronger than a corrosiveness of the second etching solution, and/or a concentration of the first etching solution is greater than a concentration of the second etching solution. The comparison of corrosiveness refers to corrosiveness of the etching solution to the doped polysilicon layer. For example, under the same concentration, an effective component in the first etching solution has stronger alkalinity relative to an effective component in the second etching solution (for example, the first etching solution uses a strong alkali and the second etching solution uses a weak alkali). In an optional embodiment, a mold can be used to form a barrier between the edge portion 102 and the middle portion 101, so as to confine the first etching solution within the middle portion 101, and confine the second etching solution within the edge portion 102, thereby enabling the first etching solution to etch the non-grid-line region 120 of the middle portion 101 and the second etching solution to etch the non-grid-line region 120 of the edge portion 102. In another optional embodiment, a temporary mask can be used to cover the edge portion 102, and the first etching solution etches the non-grid-line region 120 of the middle portion 101. The temporary mask on the edge portion 102 is then removed and a temporary mask is placed on the middle portion 101, and the second etching solution etches the non-grid-line region 120 of the edge portion 102. The temporary mask on the middle portion 101 is then removed.

In other optional embodiments, non-uniform etching can also be achieved by applying different etching durations to etch the non-grid-line regions 120 of the middle portion 101 and the edge portion 102. For example, an etching duration of the middle portion 101 is greater than an etching duration of the edge portion 102. In such a case, the non-grid-line region 120 of the middle portion 101 of the silicon wafer 100 is etched deeper relative to the non-grid-line region 120 of the edge portion 102. Optionally, the etching durations of the non-grid-line region 120 of the middle portion 101 and the non-grid-line region 120 of the edge portion 102 are selected based on related factors, such as the parameters of the etching solution, a thickness of the doped polysilicon layer, and an allowable etching depth of the silicon wafer 100. For example, the etching duration of the middle portion 101 is 3 min-5 min and the etching duration of the edge portion 102 is 2 min-4 min. In an optional embodiment, all non-grid-line regions 120 at the back surface of the solar cell sheet 010 can be first etched for a first duration (for example, 2 min-4 min), and then a mold is used to form a barrier between the edge portion 102 and the middle portion 101 to confine the etching solution within the middle portion 101, and the non-grid-line region 120 of the middle portion 101 is further etched for a second duration (for example, 30 s-180 s). In another optional embodiment, all non-grid-line regions 120 at the back surface of the solar cell sheet 010 can be first etched for a first duration (for example, 2 min-4 min), and a temporary mask covers the edge portion 102. The etching solution then further etches the non-grid-line region 120 of the middle portion 101 for a second duration (for example, 30 s-180 s). Due to the temporary mask, the non-grid-line region 120 of the edge portion 102 is not etched in this process. The temporary mask is then removed.

In other optional embodiments, non-uniform etching can be achieved by applying different process temperatures to etch the non-grid-line regions 120 of the middle portion 101 and the edge portion 102. For example, an etching temperature of the middle portion 101 is greater than an etching temperature of the edge portion 102. It is understood that higher temperature typically leads to better thermodynamic and kinetic conditions for a chemical reaction, which promotes the reaction and increases a reaction rate. Therefore, when an etching temperature of the middle portion 101 is greater than an etching temperature of the edge portion 102, the non-grid-line region 120 of the middle portion 101 of the silicon wafer 100 is etched deeper relative to the non-grid-line region 120 of the edge portion 102. For example, an etching temperature of the edge portion 102 is room temperature, and an etching temperature of the middle portion 101 is 30 °C-60 °C. A heating device can be used to synchronously heat the middle portion 101 of the silicon wafer 100 during the etching process, or the middle portion 101 of the silicon wafer 100 can be preheated to raise a temperature of the middle portion 101 to a target etching temperature before performing wet etching on the doped polysilicon layer on the silicon wafer 100.

When producing the solar cell sheet 010 (TOPCon cell) shown in FIG. 2, the wet etching process removes, in addition to the doped polysilicon layer in the non-grid-line region 120, the tunneling oxide layer 500 in the non-grid-line region 120, resulting in the structure shown in FIG. 10.

When producing the solar cell sheet 010 (BC cell) shown in FIG. 4, the wet etching process can remove a portion of the n-type doped polysilicon layer 400 and a corresponding portion of the second dielectric layer 410 to expose the non-grid-line region 120 of the silicon wafer 100. Alternatively, a portion of the p-type doped polysilicon layer 300 and a corresponding portion of the first dielectric layer 310 to expose the non-grid-line region 120 of the silicon wafer 100 can be removed. Alternatively, a portion of the n-type doped polysilicon layer 400 and its corresponding portion of second dielectric layer 410 can be removed, and a portion of the p-type doped polysilicon layer 300 and its corresponding portion of first dielectric layer 310 can be removed to expose the non-grid-line region 120 of the silicon wafer 100. The finally obtained structure is as shown in FIG. 11.

In the embodiment of the present invention, grooves are formed in the non-grid-line regions 120 of both the middle portion 101 and the edge portion 102 of the silicon wafer 100 through the wet etching process, wherein a groove depth of the non-grid-line region 120 of the middle portion 101 is 1 µm-5 µm, and a groove depth of the non-grid-line region 120 of the edge portion 102 is 0.1 µm-3 µm. Since the non-grid-line region 120 of the middle portion 101 of the silicon wafer 100 is etched deeper, a thickness of the silicon wafer 100 at the non-grid-line region 120 of the middle portion 101 is smaller than a thickness of the silicon wafer 100 at the non-grid-line region 120 of the edge portion 102. This structure, of which the edge portion is thick and the middle portion is thin, facilitates prevent the wafer warpage and provides convenience for subsequent processing and assembly. Moreover, a thicker edge can effectively reduce a risk of damage to the solar cell sheet 010 caused by impact. Optionally, the etching solution used in the wet etching process comprises at least one of sodium hydroxide and potassium hydroxide.

Step S400: forming grid lines 200 connected to the doped polysilicon layer.

In the embodiment of the present invention, the first grid line 201 is connected to the p-type doped polysilicon layer 300, and the second grid line 202 is connected to the n-type doped polysilicon layer 400.

For example, when producing the solar cell sheet 010 (TOPCon cell) shown in FIG. 2, prior to forming the first grid line 201 and the second grid line 202, a first passivation layer 610 can be formed on a side of the p-type doped polysilicon layer 300 away from the silicon wafer 100, and a second passivation layer 620 can be formed on the non-grid-line region 120 at the back surface of the silicon wafer 100 and on a side of the n-type doped polysilicon layer 400 away from the silicon wafer 100. The first grid line 201 and the second grid line 202 are then fabricated to obtain the solar cell sheet 010 shown in FIG. 2.

For example, when producing the solar cell sheet 010 (BC cell) shown in FIG. 4, prior to forming the first grid line 201 and the second grid line 202, the first passivation layer 610 can be formed on a front surface of the silicon wafer 100, and the second passivation layer 620 can be formed on the non-grid-line region 120 at the back surface of the silicon wafer 100 and on a side of the p-type doped polysilicon layer 300 and the n-type doped polysilicon layer 400 away from the silicon wafer 100. The first grid line 201 and the second grid line 202 are then formed to obtain the solar cell sheet 010 shown in FIG. 4.

Optionally, the first passivation layer 610 and the second passivation layer 620 can be fabricated using a vapor deposition process or an atomic layer deposition process. The first passivation layer 610 and the second passivation layer 620 can be a single-layer structure formed of a single material (for example, an aluminum oxide layer, a silicon oxide layer, a silicon oxynitride layer, or a silicon nitride layer), or a composite layer structure formed of multiple materials.

During formation of the grid line 200, the second grid line 202 is printed on the second passivation layer 620 in a region corresponding to the n-type doped polysilicon layer 400. The first grid line 201 is then printed on the first passivation layer 610 in a region corresponding to the p-type doped polysilicon layer 300. Finally, the first grid line 201 and the second grid line 202 are sintered. The solar cell sheet 010 can be finally obtained as shown in FIG. 2 or FIG. 4.

The embodiment of the present invention further provides a photovoltaic module (not shown in figure), which includes the solar cell sheet 010 provided in the above embodiments of the present invention, or includes the solar cell sheet 010 obtained by the preparation method provided in the above embodiments of the present invention.

In summary, the present embodiment provides a solar cell sheet 010, a preparation method therefor, and a photovoltaic module. The solar cell sheet 010 provided by embodiment of the present invention is a tunnel oxide passivated contact cell or a back contact cell, which comprises a silicon wafer 100, a doped polysilicon layer, and grid lines 200. At least one surface of the silicon wafer 100 has a grid-line region 110 and a non-grid-line region 120, the doped polysilicon layer covers the grid-line region 110, and the grid lines 200 are connected to the doped polysilicon layer. The silicon wafer 100 has a middle portion 101 and an edge portion 102, the edge portion 102 forms an edge of the silicon wafer 100 and surrounds the middle portion 101, and a thickness of the silicon wafer 100 at the non-grid-line region 120 of the edge portion 102 is greater than a thickness of the silicon wafer 100 at the non-grid-line region 120 of the middle portion 101. In embodiments of the present invention, since the non-grid-line region 120 of the edge portion 102 has a greater thickness relative to the non-grid-line region 120 of the middle portion 101, structural strength thereof is better than that of the middle portion 101. Since the edge portion 102 is exactly a position prone to warping and micro-cracking and also a position prone to being bumped, strengthening the edge portion 102 of the silicon wafer 100 in embodiments of the present invention can improve reliability of the entire silicon wafer 100 and even the entire solar cell sheet 010. This makes the silicon wafer 100 and the solar cell sheet 010 not prone to warping, micro-cracking, or fragmenting, and not prone to being damaged due to impact. In processing of the solar cell sheet 010, in assembly of a photovoltaic module, and in subsequent use of the photovoltaic module, a silicon wafer 100 having better reliability can enable the solar cell sheet 010 to have a higher product yield, better performance, and a longer service life.

The preparation method of the solar cell sheet 010 provided by embodiments of the present invention can be used for preparing the above solar cell sheet 010, and the photovoltaic module provided by embodiments of the present invention comprises the above solar cell sheet 010 or the solar cell sheet 010 prepared by the above preparation method. Therefore, the photovoltaic module also has characteristics of high product yield, good reliability, and long service life.

The above is only a specific embodiment of the present invention, but the scope of protection of the present invention is not limited thereto. Any person skilled in the art can easily envisage changes or substitutions within the technical scope disclosed in the present invention, which should be encompassed within the scope of protection of the present invention.

## Claims

1. A solar cell sheet, **characterized in that** the solar cell sheet (010) is a tunnel oxide passivated contact cell or a back contact cell; the solar cell sheet (010) comprises a silicon wafer (100), a doped polysilicon layer, and grid lines (200), wherein at least one surface of the silicon wafer (100) has a grid-line region (110) and a non-grid-line region (120); the doped polysilicon layer covers the grid-line region (110); the grid lines (200) are connected to the doped polysilicon layer; and
the silicon wafer (100) has a middle portion (101) and an edge portion (102), wherein the edge portion (102) forms an edge of the silicon wafer (100) and surrounds the middle portion (101), a dimension of the edge portion (102) in a width direction of the edge portion (102) is 1% to 30% of a dimension of the silicon wafer (100) in the same direction; a width direction of the edge portion (102) is parallel to the silicon wafer (100) and perpendicular to the edge of the silicon wafer (100); and a thickness of the silicon wafer (100) at the non-grid-line region (120) in the edge portion (102) is greater than a thickness of the silicon wafer (100) at the non-grid-line region (120) in the middle portion (101).

2. The solar cell sheet according to claim 1, wherein the dimension of the edge portion (102) in the width direction of the edge portion (102) is 1 mm to 70 mm.

3. The solar cell sheet according to claim 1, wherein the non-grid-line region (120) of the silicon wafer (100) forms a groove, and a depth of the groove in the edge portion (102) is less than a depth of the groove in the middle portion (101).

4. The solar cell sheet according to claim 3, wherein the depth of the groove in the edge portion (102) is 0.1 µm to 3 µm, and the depth of the groove in the middle portion (101) is 1 µm to 5 µm.

5. The solar cell sheet according to claim 3, wherein the groove is formed on a back surface of the silicon wafer (100).

6. A preparation method for the solar cell sheet according to any one of claims 1-5, **characterized by** comprising:
obtaining the silicon wafer;
depositing the doped polysilicon layer on the silicon wafer;
etching to remove the doped polysilicon layer and a portion of the silicon wafer in the non-grid-line region, wherein an etching depth of the silicon wafer in the middle portion is greater than an etching depth of the silicon wafer in the edge portion; and
forming the grid lines connected to the doped polysilicon layer.

7. The preparation method for the solar cell sheet according to claim 6, wherein the step of etching to remove the doped polysilicon layer and a portion of the silicon wafer in the non-grid-line region comprises:
irradiating the doped polysilicon layer in the non-grid-line region with a laser; and
removing the doped polysilicon layer and the portion of the silicon wafer in the non-grid-line region by a wet etching process.

8. The preparation method for the solar cell sheet according to claim 7, wherein in the step of irradiating the doped polysilicon layer in the non-grid-line region with a laser, a unit area laser energy of the non-grid-line region in the middle portion is greater than a unit area laser energy of the non-grid-line region in the edge portion.

9. The preparation method for the solar cell sheet according to claim 8, wherein the unit area laser energy of the non-grid-line region in the middle portion is 210 mJ/cm² to 380 mJ/cm²; and the unit area laser energy of the non-grid-line region in the edge portion is 180 mJ/cm² to 350 mJ/cm².

10. The preparation method for the solar cell sheet according to claim 8, wherein in the step of irradiating the doped polysilicon layer in the non-grid-line region with a laser, an irradiation duration of the non-grid-line region in the middle portion is greater than an irradiation duration of the non-grid-line region in the edge portion, and/or an irradiation power of the non-grid-line region in the middle portion is greater than an irradiation power of the non-grid-line region in the edge portion.

11. The preparation method for the solar cell sheet according to claim 7, the step of removing the doped polysilicon layer and the portion of the silicon wafer in the non-grid-line region by a wet etching process comprises:
etching the non-grid-line region in the middle portion using a first etching solution, and etching the non-grid-line region in the edge portion using a second etching solution, wherein
a corrosiveness of the first etching solution is stronger than a corrosiveness of the second etching solution, and/or a concentration of the first etching solution is greater than a concentration of the second etching solution.

12. The preparation method for the solar cell sheet according to claim 7, wherein in the step of removing the doped polysilicon layer and the portion of the silicon wafer in the non-grid-line region by a wet etching process, an etching duration of the middle portion is greater than an etching duration of the edge portion, and/or an etching temperature of the middle portion is higher than an etching temperature of the edge portion.

13. The preparation method for the solar cell sheet according to any one of claims 7-12, wherein the laser is a green laser.

14. The preparation method for the solar cell sheet according to any one of claims 7-12, wherein the etching solution used in the wet etching process comprises at least one of sodium hydroxide and potassium hydroxide.

15. A photovoltaic module, **characterized by** comprising the solar cell sheet according to any one of claims 1-5, or comprising the solar cell sheet prepared by the preparation method for the solar cell sheet according to any one of claims 6-14.
